# EUROPEAN PATENT SPECIFICATION

(11) **EP 2 813 858 B1**
(45) Date of publication and mention of the grant of the patent: **08.06.2016**
(21) Application number: 13172041.9
(22) Date of filing: 14.06.2013
(51) Int. Cl.: G01R 31/28, G01R 31/319

(54) **Method of contacting integrated circuit components in a test system**
Verfahren zur Kontaktierung von integrierten Schaltkomponenten in einem Prüfsystem
Procédé de mise en contact des composants de circuit intégré dans un système de test

(43) Date of publication of application: 17.12.2014
(60) Divisional application: 16164874.6
(73) Proprietor: Rasco GmbH, 83059 Kolbermoor (DE)
(72) Inventor: Croce, Karl, 83334 Inzell (DE)
(74) Representative: Grünecker Patent- und Rechtsanwälte PartG mbB

(56) References cited:
- JP-A- 2009 111 246
- KR-A- 20090 038 726
- US-A- 4 757 255
- US-A- 4 954 774
- US-B1- 6 194 907
- US-B1- 6 259 264

## Description

### Field of the Invention

The present invention relates to a method of contacting integrated circuit components in a test system and to a corresponding test system.

### Prior Art

For testing the quality of integrated circuits components (ICs) the ICs are brought into contact with a contactor body of an automatic test system to verify their function. Based on the test results, the ICs may be sorted to make them available for packaging or other applications. To do so, contactor bodies having contacting elements with contacting tips for contacting the corresponding contact areas of an IC during the test. Test signals are send via the contactor tips to the IC and response signals are received in return. Such test systems are disclosed in US 6 194 907 B1, KR 2009 0038726 A, US 4 757 255 A, JP 2009 111 246 A or US 4 954 774 A.

The contact areas / leads of ICs often comprise copper (Cu) having a coating with a material such as nickel (Ni), palladium (Pd), gold (Au) or tin (Sn). When contacting the contact areas / leads of ICs the contacting tips of the test system for testing the ICs for proper function, with respect to the at high and/or low temperatures, for example, swarf is generated due to the relative motion between the contacting tips of contactor springs and the leads of the IC under test. The contactor tips partially abrade the coating of the leads. This swarf accumulates on the contacting tips and oxidizes. The oxidized debris has a low electrical conductance, resulting in an increase of the contact resistance. Such an effect is particularly observed when testing ICs with leads having a pure tin coating.

This effect is disadvantageous and causes problems because it may lead to wrong test results and/or causes dead time of the testing apparatus, for cleaning purposes or for replacing the contactor bodies with the contacting tips.

### Description of the Invention

The problem underlying the present invention in view of the prior art is to provide a method of contacting integrated circuit components in a test system overcoming the disadvantages of contacting the ICs according to the prior art.

The above-mentioned problem is solved by the method of contacting integrated circuit components according to claim 1.

The method of contacting integrated circuit components according to the invention comprises the steps of providing an atmosphere comprising an inert gas; and contacting contact regions (contact tips) of a contact socket with respective contacting areas of an integrated circuit component to be tested, the contacting being performed in the provided atmosphere comprising the inert gas.

This method according to the invention has the advantage that the atmosphere comprising the inert gas reduces or avoids the oxidization of the abrasion debris on the contacting tips of the contact socket. Accordingly, the contact resistance remains at a lower level when compared to the same procedure under air atmosphere.

The inventive method can be developed such that the inert gas comprises at least one gas selected from the group including nitrogen, carbon dioxide and the noble gases, in particular from the group including nitrogen, helium, neon and argon, and wherein the inert gas preferably comprises nitrogen. Each of these gases reduces the oxidization of abrasion debris, in particular tin from tin-coated leads of ICs. In particular using nitrogen is preferred, since this gas can be used for cooling the ICs when performing low temperature tests (below 20°C, down to -30°C), for mid-range temperatures tests (20°C to 42°C) and also for high temperature tests (42°C or more, up to 175°C).

According to another development, the atmosphere comprising an inert gas is provided continuously. This has the advantage that the complete contacting procedure can be performed under the atmosphere with the inert gas, such that the fraction of air, in particular oxygen, in the provided atmosphere can be kept at a low level.

The inert gas may, on the other hand, be provided repeatedly but only when necessary to improve the conductivity at the tips of the contacting elements. Hence, tests may be normally performed under air atmosphere interrupted with cycles of providing an inert gas atmosphere until the contact resistance is reduced below a given threshold.

In a further development the inert gas has a temperature of at least 42°C, in particular a temperature in the range of 42°C to 175°C, preferably in the range of 50°C to 175°C, most preferably in the range of 100°C to 175°C. Accordingly, the inert gas atmosphere is provided at temperature for conducting high temperature tests of ICs.

According to another development, the inert gas has a temperature of less than 42°C, in particular in the range of -30°C to 20°C or 20°C to 42°C. The inert gas may thus be used to cool the ICs under test to perform mid temperature and/or low temperature tests.

According to another development, the method comprises the further step of heating or cooling the inert gas. Hence, the inert gas can be provided at a desired temperature by heating or cooling it, depending on the initial temperature of the inert gas before heating or cooling.

The above-mentioned problem is further solved by a contact socket for testing integrated circuit components according to independent claim 7.

The contact socket for testing integrated circuit components according to the invention comprises contact regions (contact tips), in particular contact springs each comprising a contact region (contact tip), for contacting respective contacting areas of an integrated circuit component; means for providing an atmosphere comprising an inert gas; wherein the contact socket is configured to perform contacting of an integrated circuit component in the provided atmosphere under operating conditions.

The contact socket may be further developed such that the means for providing an atmosphere comprising an inert gas include at least one nozzle for directing a flow of inert gas to the contact tips of the contact socket. Hence, the flow of the inert gas can be concentrated to the points of contact of the contact socket and an IC.

The contact socket may further comprise an inert gas chamber defining a space for the atmosphere comprising an inert gas. This has the advantage that the atmosphere comprising the inert gas is confined to a small volume and therefore reduces the total amount of inert gas required.

The contact socket may be further developed such that the inert gas chamber comprises a gas inlet for introducing the inert gas into the chamber and a gas outlet for discharging the inert gas.

The invention further provides a contactor for contacting an integrated circuit component, comprising the contact socket according to the invention or one of its developments, and a contact holder for holding an integrated circuit.

The contactor may further comprise means for heating the inert gas and / or means for cooling the inert gas.

According to the invention, the gas outlet and the gas inlet are interconnected outside of the chamber to provide a recirculation circuit for the inert gas. The recirculation circuit further reduces the required amount of inert gas.

The invention also provides a test system for testing integrated circuit components, comprising a contactor or a plurality of contactors according to the invention or one of its developments, in particular, and may further comprise a handler for feeding integrated circuit components to the contactor or the plurality of contactors.

According to another development, the integrated circuit components may be provided as parts of a test strip including a plurality of separate integrated circuit components or the integrated circuit components may be provided as parts of a waver probe including a plurality of integrated circuit components.

The advantages of the test system and its developments correspond to the advantages given above for the method according to the inventions and its developments.

Further features and advantages of the present invention will be described in the following with reference to the figures, which illustrate only examples of embodiments of the present invention. The illustrated and described features may be suitably combined with each other.

### Brief Description of the Drawings

- Fig. 1: illustrates a test system according to the prior art.
- Fig. 2: illustrates an embodiment of the contact socket according to the invention.
- Fig. 3A;B;C;D: illustrate another embodiment of the invention.
- Fig. 4: illustrate a further embodiment of the invention.
- Fig. 5: illustrates a test result when performing the method according to the invention

### Description of the Embodiments

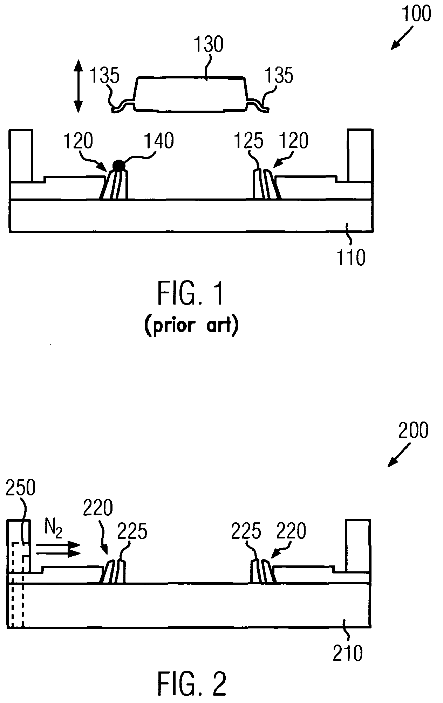

Figure 1 shows a test system / contactor according to the prior art.

The test system 100 has a contact socket 110 having contact elements 120 with contacting tips 125 for contacting respective contact areas (e.g. leads) 135 of an integrated circuit 130 during a test. The IC 130 is placed in the test system 100 and moved towards the contact socket 110 (arrow down) until the tips 125 of the contacting elements (e.g. springs) are in contact with the leads 135 of the IC 130. After the test has been performed the IC 130 is lifted (arrow up), can be removed and be replaced with the next IC to be tested. Due to the slight relative movement between the tips 125 and the leads 135, portions of tin are scraped of the leads 135 and may cover the tips 125. This tin chemically reacts with the oxygen in the surrounding air and oxidizes forming a layer of debris 140 on the tips 125. This oxidized tin has a high electrical resistance, which may lead to a malfunctioning of the test system 100. The contact resistance can be easily measured by applying a particular voltage while measuring the current through the contact elements 120. Internal tests performed by the applicant have revealed that nitrogen may preferably be used for temperature tests of ICs below 42°C, in particular also for the range of 20°C to 42 °C as the conditioning of nitrogen can be better controlled than that of air.

Figure 2 shows an embodiment of a contact socket according to the invention.

The test system 200 according to the invention comprises similar components as the test system according to Fig. 1. The corresponding reference numbers for similar components are increased by 100. The test system 200 further comprises means 250 for providing an atmosphere comprising an inert gas, and in this embodiment the inert gas is N₂. The means 250 may be formed of a line 250 for conducting the nitrogen to a nozzle at the end of the line 250. The test system 200 is configured such that the contact tips 225 of the contact socket 210 of the test system 200 are contacting respective contacting areas 235 of an integrated circuit component 230 to be tested, and the test system 200 is configured to perform the contacting in the provided nitrogen atmosphere under operating conditions. The nitrogen atmosphere suppresses the oxidization of the debris which occasionally falls off the tips 225, for example during the next contacting cycle. A contactor comprising the contact socket 210 of this embodiment may further comprise heating means that may heat the nitrogen gas to perform a high temperature function test of the IC 230.

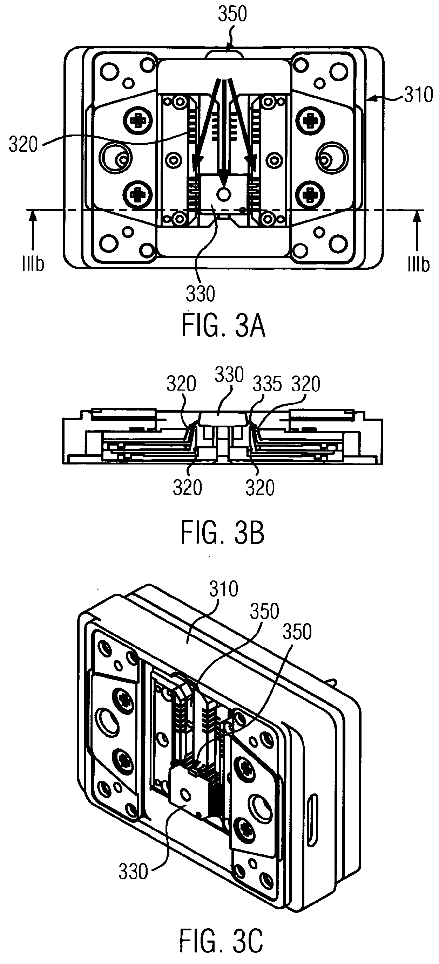

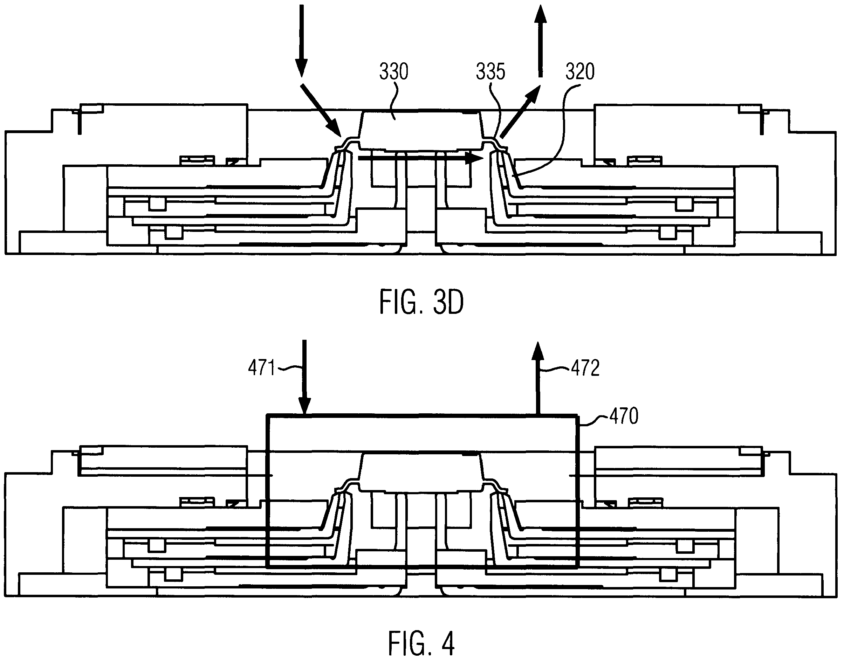

Figure 3 A; B; C; D illustrate another embodiment of the invention.

The contact socket 310 according to this embodiment of the invention comprises similar components as the contact socket 210 according to Fig. 2. The corresponding reference numbers for similar components are increased by 100. Figure 3A is a plan view on the contact socket 310. Fig. 3B is a cross sectional view along line C-C in Fig. 3A. Fig 3C is perspective view of the contact socket 310 and Fig. 3D illustrates the flow of inert gas around the contact sites. In all views an IC 330 is located in the contact socket with IC leads 335 contacting respective contact springs 320 of the contact socket 310. Nozzles 350 are provided in the contact socket 310 for directing the flow of inert gas (e.g. nitrogen) to the contacting sites.

Figure 4 illustrate a further embodiment of the invention.

In Figure 4, additionally to the embodiment of Figure 3, an inert gas chamber 470 is provided. Moreover, a gas inlet 471 and a gas outlet 472 are provided. Accordingly, a limited volume has to be filled with inert gas and further, optionally a circular flow of inert gas can be implemented, further reducing the consumption of inert gas.

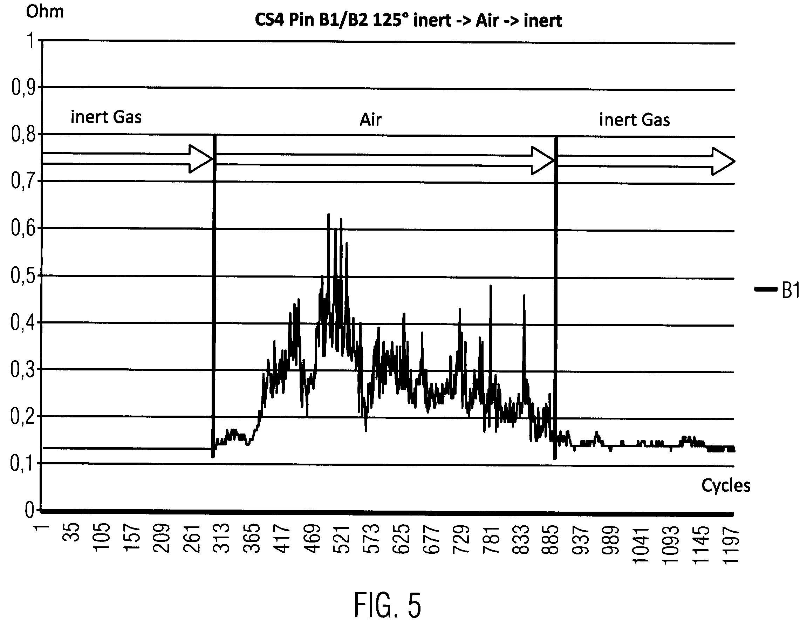

Figure 5 shows test results when performing the method according to the invention when compared with the method according to the prior art.

Figure 5 shows a test performed at a representative contacting site CS4 of a contactor in a test system. The vertical axis represents the resistance in Ohm and the horizontal axis represents the number of contacted ICs. Inert gas (Nitrogen) or air is supplied at a temperature of 125°C. When air is supplied, the contact resistance increases and then shows statistical changes, however, always at a level that significantly causes problems for performing the desired test. In contrast, when nitrogen is supplied and the contacting of the tips of the contactor and the leads of the ICs is performed in a nitrogen atmosphere, the contact resistance remains at a low level that does not influence the test. First a nitrogen atmosphere is provided until the 280^{th} contacting, second an air atmosphere is provided from the 281^{st} until the 920^{th} contacting, and finally again a nitrogen atmosphere is provided from the 921^{st} contacting onward. It is evident that even when oxidized debris increasing the contact resistance has already been present, there is a recovery to a low contact resistance when the nitrogen gas is supplied.

## Claims

1. A method of contacting integrated circuit components in a chamber, comprising the steps of:
providing an atmosphere comprising an inert gas; and
contacting contact regions, in particular contact regions of contact springs, of a contact socket with respective contacting areas of an integrated circuit component to be tested, the contacting being performed in the provided atmosphere comprising the inert gas;
**characterized in that**
the inert gas has a temperature of at least 42°C;
wherein the atmosphere comprising the inert gas is provided continuously by interconnecting a gas outlet and a gas inlet outside of the chamber to provide a recirculation circuit for the inert gas, and
a flow of the inert gas is directed and concentrated to the contact regions of the contact socket by means of nozzles provided in the contact socket.

2. The method of claim 1, wherein the inert gas comprises at least one gas selected from the group including nitrogen and the noble gases, in particular from the group including nitrogen, helium, neon and argon, and wherein the inert gas preferably comprises nitrogen.

3. The method of one of claims 1 to 2, wherein the inert gas has a temperature in the range of 42°C to 175°C, preferably in the range of 50°C to 175°C.

4. The method of one of claims 1 to 3, further comprising the step of heating the inert gas and/or further comprising the step of cooling the inert gas.

## Patentansprüche

1. Verfahren zum Kontaktieren von integrierten Schaltungskomponenten in einer Kammer, umfassend die Schritte:
Bereitstellen einer Inertgas umfassenden Atmosphäre; und
Kontaktieren von Kontaktbereichen, insbesondere Kontaktbereichen von Kontaktfedern, eines Kontaktsockels mit jeweiligen Kontaktflächen einer zu testenden integrierten Schaltungskomponente, wobei das Kontaktieren in der bereitgestellten das Inertgas umfassende Atmosphäre durchgeführt wird;
**dadurch gekennzeichnet, dass**
das Inertgas eine Temperatur von wenigstens 42°C hat;
wobei die das Inertgas umfassende Atmosphäre kontinuierlich bereitgestellt wird, indem ein Gasauslass und eine Gaseinlass außerhalb der Kammer verbunden werden, um einen Zirkulationskreis für das Inertgas bereitzustellen, und
eine Strömung von Inertgas mittels im Kontaktsockel vorgesehener Düsen zu den Kontaktbereichen des Kontaktsockels gerichtet und konzentriert wird.

2. Verfahren nach Anspruch 1, wobei das Inertgas wenigstens ein ausgewähltes Gas aus der Gruppe, die Stickstoff und die Edelgase enthält, umfasst, insbesondere aus der Gruppe, die Stickstoff, Helium, Neon und Argon enthält, und wobei das Inertgas vorzugsweise Stickstoff umfasst.

3. Verfahren nach Anspruch 1 oder 2, wobei das Inertgas eine Temperatur im Bereich von 42°C bis 175°C hat, vorzugsweise im Bereich von 50°C bis 175°C.

4. Verfahren nach einem der Ansprüche 1 bis 3, weiterhin den Schritt Heizen des Inertgases und/oder den Schritt Kühlen des Inertgases umfassend.

## Revendications

1. Procédé de mise en contact de composants de circuit intégré dans une chambre, comprenant les étapes consistant à :
fournir une atmosphère comprenant un gaz inerte ; et
mettre en contact des régions de contact, en particulier les régions de contact de ressorts de contact, d'une prise de contact avec des zones de mise en contact respectives d'un composant de circuit intégré à soumettre à essai, la mise en contact étant effectuée dans l'atmosphère fournie comprenant le gaz inerte ;
**caractérisé en ce que**
le gaz inerte est à une température d'au moins 42 °C ;
dans lequel l'atmosphère comprenant le gaz inerte est fournie en continu par interconnexion d'une sortie de gaz et d'une entrée de gaz extérieure à la chambre pour fournir un circuit de remise en circulation pour le gaz inerte, et
l'écoulement du gaz inerte est dirigé et concentré vers les régions de contact de la prise de contact au moyen de buses prévues dans la prise de contact.

2. Procédé selon la revendication 1, dans lequel le gaz inerte comprend au moins un gaz choisi dans le groupe incluant l'azote et les gaz nobles, en particulier dans le groupe incluant l'azote, l'hélium, le néon et l'argon et dans lequel le gaz inerte comprend de préférence de l'azote.

3. Procédé selon l'une des revendications 1 ou 2, dans lequel le gaz inerte est à une température se situant dans la plage de 42 °C à 175 °C, de préférence dans la plage de 50 °C à 175 °C.

4. Procédé selon l'une des revendications 1 à 3, comprenant en outre l'étape de chauffage du gaz inerte et/ou comprenant en outre l'étape de refroidissement du gaz inerte.
